# EUROPEAN PATENT APPLICATION

(11) **EP 3 553 943 A1**
(43) Date of publication of application: **16.10.2019**
(21) Application number: 18197075.7
(22) Date of filing: 27.09.2018
(51) Int. Cl.: H02S 20/25

(54) **PHOTOVOLTAIC TILE AND PHOTOVOLTAIC SYSTEM**

(30) Priority: 14.04.2018 CN 201810334434; 11.06.2018 CN 201810596495
(71) Applicant: Guangdong Hanergy Thin-Film Solar Co., Ltd., Heyuan, Guangdong 517000 (CN)
(72) Inventor: ZHU, Yanjun, Guangdong, 517000 (CN); PENG, Fuqiang, Guangdong, 517000 (CN); SUN, Shulong, Guangdong, 517000 (CN); TIAN, Jinhu, Guangdong, 517000 (CN)
(74) Representative: Nordmeyer, Philipp Werner

(57) **Abstract**

A photovoltaic tile (100; 200) and a photovoltaic system (300) are disclosed. The photovoltaic tile (100; 200) includes a tile base (1) including a flat plate portion (10) and at least one bulging portion (11, 12) connected to the flat plate portion (10); a first cell piece (2), which is a flat cell piece, is formed on an outer surface of the flat plate portion (10), and a second cell piece (3) matched with an outer surface of at least one of the bulging portions (11, 12) is formed on the outer surface of the at least one of the bulging portions (11, 12). The photovoltaic system (300) includes the above-mentioned photovoltaic tile (100; 200).

## Description

### CROSS-REFERENCE TO RELATED APPLICATION

This application claims priorities to Chinese patent applications No. 201810334434.3 titled "A Photovoltaic tile and photovoltaic system" filed on April 14, 2018, and No. 201810596495.7 titled "A PHOTOVOLTAIC TILE AND PHOTOVOLTAIC SYSTEM" filed on June 11, 2018 with the China Patent Office, the disclosures of which are incorporated herein by reference in their entirety.

### TECHNICAL FIELD

The present disclosure relates to the technical field of photovoltaic technology, and especially relates to a photovoltaic tile and a photovoltaic system (also known as photovoltaic power generation system).

### BACKGROUND

With the photovoltaic technology becoming mature, it is gradually applied into the construction field and forms a Building Integrated Photovoltaic (BIPV) technology which integrates photovoltaic power generation and construction/architecture technologies, enabling traditional buildings a photovoltaic power generation function. For example, photovoltaic technology is applied to tiles to form solar power tiles with a photovoltaic power generation function.

### SUMMARY

An aspect of the present disclosure provides a photovoltaic tile, the photovoltaic tile including a tile base, a first cell piece and a second cell piece, wherein the tile base includes a flat plate portion and at least one bulging portion connected to the flat plate portion, the first cell piece is disposed on an outer surface of the flat plate portion, and the second cell piece is disposed on and matched (fit) with an outer surface of at least one of the bulging portions.

In some embodiments, the first cell piece is a flat cell piece and the second cell piece is a flexible cell piece.

In some embodiments, the first cell piece and the second cell piece are connected in parallel.

In some embodiments, a terminal voltage of the first cell piece is equal to a terminal voltage of the second cell piece.

In some embodiments, the photovoltaic tile further includes a bypass module connected in parallel with the first and the second cell pieces.

In some embodiments, the photovoltaic tile further includes a first reverse charging prevention module and a second reverse charging prevention module; wherein the first cell piece is connected in series with the first reverse charging prevention module with a positive pole of the first cell piece connected to the first reverse charging prevention module; and the second cell piece is connected in series with the second reverse charging prevention module with a positive pole of the second cell piece connected to the second reverse charging prevention module.

In some embodiments, the photovoltaic tile further includes a junction box disposed on an inner surface of the flat plate portion, wherein each of the first reverse charging prevention module, the second reverse charging prevention module and the bypass module is disposed in the junction box.

In some embodiments, the first cell piece includes a plurality of sub-first cell pieces connected in series.

In some embodiments, the second cell piece includes a plurality sets of sub-second cell pieces connected in parallel, the second reverse charging prevention module includes a plurality of sub-second reverse charging prevention modules connected in series with the plurality sets of sub-second cell pieces in a one-to-one relation, and wherein positive poles of the plurality sets of sub-second cell pieces are connected to the plurality of sub-second reverse charging prevention modules in a one-to-one relation.

In some embodiments, the plurality sets of sub-second cell pieces are arranged on the outer surface of the bulging portion along a length direction of the tile base.

In some embodiments, a difference between a length of the first cell piece along the length direction of the tile base and a length of the second cell piece along the length direction of the tile base is less than or equal to 50 mm.

In some embodiments, the photovoltaic tile further includes a cell package layer for packaging the first cell piece and the second cell piece.

Another aspect of the present disclosure provides a photovoltaic system including the photovoltaic tile according to any one of the above embodiments.

In some embodiments, each of the photovoltaic tiles (in the photovoltaic system) is connected in series.

In some embodiments, each of the photovoltaic tiles includes at least two bulging portions including a first bulging portion and a second bulging portion which are respectively connected at two ends of the tile base included in the photovoltaic tile in a width direction of the tile base; among two of the photovoltaic tiles adjacent in the width direction of the tile base, an outer surface of the second bulging portion included in one photovoltaic tile is in contact with an inner surface of the first bulging portion included in the other photovoltaic tile; and two of the photovoltaic tiles adjacent in a length direction of the tile base are lapped together.

### BRIEF DESCRIPTION OF THE DRAWINGS

The drawings described herein are merely exemplary and are used only for the purpose of explaining the present disclosure, and should not be interpreted as limitations to the disclosure. In the drawings:
Fig. 1 is a top view of a photovoltaic tile provided in some embodiments of the disclosure;
Fig. 2 is a perspective view of the photovoltaic tile shown in Fig. 1;
Fig. 3 is a schematic view showing a position of a junction box on the tile base in the photovoltaic tile shown in Fig. 1;
Fig. 4 is a schematic view showing a position of a bus bar on the tile base in the photovoltaic tile shown in Fig. 1;
Fig. 5 is a schematic view showing a cell package layer packaging the first cell piece and the second cell piece in the photovoltaic tile of Fig. 1;
Fig. 6 is a circuit diagram of a reverse charging prevention circuit in the photovoltaic tile of Fig. 1;
Fig. 7 is a prospective view of a photovoltaic tile provided in some other embodiments of the disclosure;
Fig. 8 is a first circuit diagram of a reverse charging prevention circuit in the photovoltaic tile of Fig. 7;
Fig. 9 is a second circuit diagram of a reverse charging prevention circuit in the photovoltaic tile of Fig. 7; and
Fig. 10 is a structural schematic view of a photovoltaic system provided in some embodiments of the disclosure.

### DETAILED DESCRIPTION

The technical solutions in the embodiments of the present disclosure will be described clearly and completely below with reference to the accompanying drawings in the embodiments of the disclosure. Obviously, the described embodiments are merely a part but not all embodiments of the present disclosure. All other embodiments obtained by those ordinarily skilled in the art based on the embodiments of the present disclosure without paying any creative effort shall be included in the protection scope of the present disclosure.

In the related art, a solar power tile includes a tile base and a crystalline silicon cell piece disposed on a light receiving surface of the tile base. The solar power tile uses the crystalline silicon cell piece to absorb solar energy and converts it into electrical energy for use by a user. However, when the solar power tile serves as a building material, an edge portion of the tile base of each solar power tile generally has a curved or special-shaped structure to achieve a lap or hardware connection between two solar power tiles. However, the crystalline silicon cell piece is usually shaped like a flat plate and is inflexible such that the crystalline silicon cell piece can only be formed in a planar area of the tile base, resulting in a small area that is actually occupied by the crystalline silicon cell piece on the tile base and insufficient utilization of the surface of the tile base, and thus resulting a low utilization rate of the tile base of the photovoltaic tile.

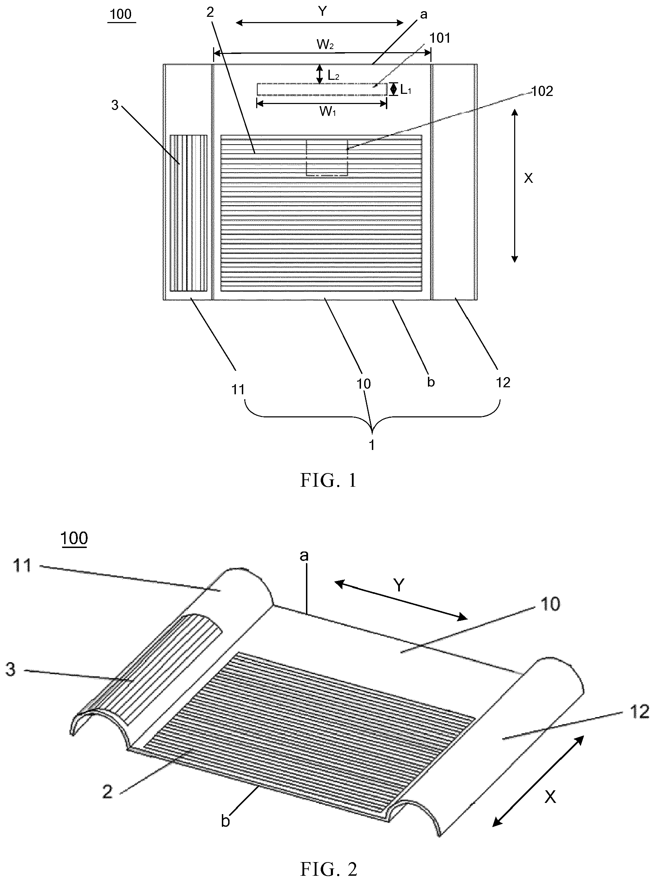

In order to solve the above problems, as shown in Figs. 1 to 3, some embodiments of the present disclosure provides a photovoltaic tile including a tile base 1, a first cell piece 2 and a second cell piece 3. The tile base 1 may be a metal tile, a clay tile, a cement tile, a ceramic tile or a glass tile, or the like, which will not be further enumerated here.

The tile base 1 includes a flat plate portion 10 and at least one bulging portion connected to the flat plate portion 10. The flat plate portion 10 and the at least one bulging portion may be an integral structure or separate structures. However, in consideration of ease of manufacture, the flat plate portion 10 and the at least one bulging portion form an integral structure. The number of the bulging portions may be one, two, or three, which is not specifically limited herein. In some embodiments, as shown in Figs. 1 to 3, the number of the bulging portions is two, i.e., the first bulging portion 11 and the second bulging portion 12.

A first cell piece 2 is formed on an outer surface of the flat plate portion 10, and a second cell piece 3 is formed on and matched with (fit with) an outer surface of at least one on the bulging portions. The bulging portion may be a bulging lap joint provided on an edge of the tile base 1 or may be a strip-shaped convex portion disposed in the middle of the tile base 1 and extending along a length direction of the tile base 1 (i.e., the direction X in Fig. 1 or 2). An outer surface of the bulging portion is in a convex state, and an inner surface of the bulging portion is in a concave state.

The specific manufacturing process of the photovoltaic tile provided in the embodiment of the disclosure is described in detail below with reference to the accompanying drawings; wherein a tile base 1 manufactured by a float flat glass is taken as an example for illustration.

Step S100: providing a float flat glass; performing toughening treatment to the float flat glass and thermally bending it into a tile base 1 according to a preset tile structure so that the tile base 1 includes a flat plate portion 10 and at least one bulging portion connected to the flat plate portion 10.

Step S200: forming a first cell piece 2 on an outer surface of the flat plate portion 10, and forming a second cell piece 3 on an outer surface of the at least one bulging portion so that the first cell piece 2 and the second cell piece 3 convert solar energy into electricity at the same time during photovoltaic power generation.

When mounting the photovoltaic tile provided in the embodiment of the disclosure, inner surfaces of the flat plate portion 10 and the at least one bulging portion of the tile base 1 included in the photovoltaic tile are disposed to face a purlin or rafter to ensure that the first cell piece 2 formed on the outer surface of the flat plate portion 10 and the second cell piece 3 formed on the outer surface of the at least one bulging portion are oriented toward light.

It can be seen from the structure of the photovoltaic tile provided in the embodiment of the disclosure and the specific manufacturing process thereof that, the tile base 1 includes a flat plate portion 10 and at least one bulging portion connected to the flat plate portion 10. Since a second cell piece 3 is formed on the outer surface of the at least one bulging portion and matched with the outer surface of the bulging portion(s), in some embodiments, the second cell piece 3 is a flexible cell piece. In this way, flexible characteristics of the second cell piece 3 may be utilized to match the second cell piece 3 with the outer surface of the bulging portion, so that the outer surface of the bulging portion, which was originally not possible to be used, forms the second cell piece 3 which can be used for power generation, thereby increasing an utilization area of the tile base 1 in the photovoltaic tile as well as the power generation amount of the photovoltaic tile.

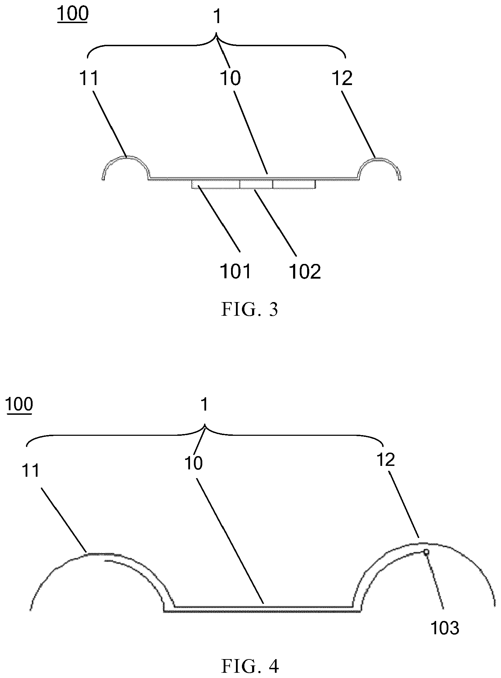

It should be understood that, as shown in Figs. 1 and 3, in an embodiment of the disclosure, a mounting block 101 is bonded, or provided in other manners, on an inner surface of the flat plate portion 10 so that the flat plate portion 10 may be lapped on a roof batten through the mounting block 101. In some embodiments, the mounting block 101 is disposed at a middle portion of the flat plate portion 10 in a width direction of the tile base 1 (i.e., the direction Y in Fig. 1 or 2) to prevent inclination and uneven stress on the tile base 1 due to unevenly distributed loads on the flat plate portion 10, thereby ensuring a life of the tile base 1. In some embodiments, as shown in Fig. 1, a width *W*₁ of the mounting block 101 is 1/3 to 1/2 of a width *W*₂ of the flat plate portion 10. It should be noted that the width *W*₁ of the mounting block 101 refers to a dimension of the mounting block 101 in the width direction of the tile base 1, and the width *W*₂ of the flat plate portion 10 refers to a dimension of the flat plate portion 10 in the width direction of the tile base 1.

In consideration of setting strength of the mounting block 101, in some embodiments, as shown in Fig. 1, a height (not shown) of the mounting block 101 is smaller than a length *L*₁ of the mounting block 101 so that the mounting block 101 has a higher structural strength. It should be noted that the height of the mounting block 101 refers to a dimension of the mounting block 101 in a direction perpendicular to a plane of the flat plate portion 10, and the length *L*₁ of the mounting block 101 refers to a dimension of the mounting block 101 in the length direction of the tile base 1.

Further, in consideration of the fact that the mounting block 101 needs to be lapped on the roof batten, a position of the mounting block 101 on the flat plate portion 10 is affected by the roof batten. In some embodiments, as shown in Fig. 1, the flat plate portion 10 includes a first end *a* and a second end *b* positioned oppositely along the length direction of the tile base 1. The mounting block 101 may be lapped on the roof batten in a matched manner as long as a distance between an end face of the mounting block 101 adjacent to the first end *a* and an end surface of the first end *a* of the flat plate portion 10 is not less than 30 mm, and the height of the mounting block 101 is not less than 20 mm.

The number of the mounting blocks 101 may be one or more, which is not specifically limited herein. When the number of the mounting blocks 101 is more than one, the plurality of mounting blocks 101 are arranged at intervals along the width direction of the tile base 1, and a midpoint of a line linking two mounting blocks 101 at opposite ends among the plurality of mounting blocks 101 is in a middle portion of the flat plate portion 10 along the width direction of the tile base 1. The plurality of mounting blocks 101 may be arranged at equal intervals or may be arranged at non-equal intervals, which is not specifically limited herein. In some embodiments, the plurality of mounting blocks 101 are arranged at equal intervals.

It should be noted that, as shown in Figs 1 to 5, the first cell piece 2 is a flat cell piece so that the first cell piece 2 is matched with the flat plate portion 10 included in the tile base 1. The flat cell piece may be a flexible cell piece or a rigid cell piece. The second cell piece 3 is a bulging cell piece that is matched with the bulging portion included in the tile base 1. The bulging cell piece may be a flexible cell piece having a good flexibility or a rigid cell piece preformed to match a shape of the bulging portion. The rigid cell piece may be a crystalline silicon cell piece, and the flexible cell piece may be an easily bendable cell piece, such as a CIGS thin film solar cell piece.

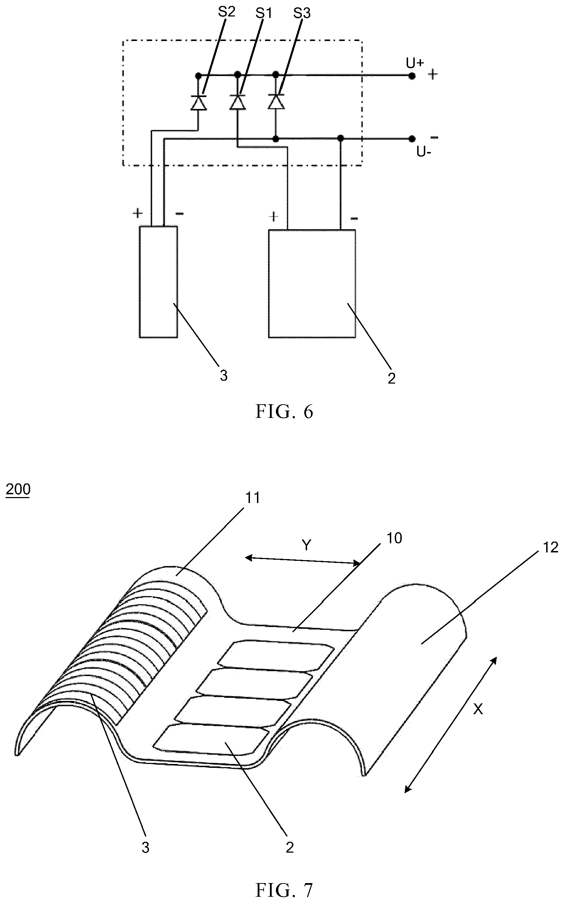

Considering the difference in structure between the bulging portion and the flat plate portion in the solar cell chip shown in Figs. 1 to 5, the light exposure angle of the first cell piece 2 is inconsistent with the light exposure angle of the second cell piece 3 so that the second cell piece 3 on the outer surface of the bulging portion has an irradiation intensity per unit area lower than that of the first cell piece 2 on the outer surface of the flat plate portion 10. Therefore, a current generated by the second cell piece 3 on the outer surface of the bulging portion is smaller than a current generated by the first cell piece 2 on the outer surface of the flat plate portion 10. If the first cell piece 2 and the second cell piece 3 are placed in a series circuit, the smaller current generated by the second cell piece 3 has a current limiting effect on the larger current generated by the first cell piece 2, so that a total current of the series circuit is equal to the smaller current generated by the second cell piece 3, and thus the smaller current generated by the second cell piece 3 consumes, in the form of heat, the larger current generated by the first cell piece 2, resulting in waste of energy and resulting the change of solar cell output voltage greatly affected by irradiation. In view of the above, as shown in Fig. 6, in an embodiment of the present disclosure, the first cell piece 2 and the second cell piece 3 are connected in parallel between a positive connection terminal U+ and a negative connection terminal U-. In this manner, a total current value output by the parallel circuit is equal to a sum of a current value output by the first cell piece 2 and a current value output by the second cell piece 3, thereby avoiding unnecessary energy waste and a problem with heat generation of the cell pieces, and thereby improving a service life of the second cell piece 3 and the first cell piece 2. At the same time, in order to avoid mutual influence between a branch where the first cell piece 2 is located and a branch where the second cell piece 3 is located, a terminal voltage (terminal voltage value) of the first cell piece 2 is equal to a terminal voltage of the second cell piece 3. In this manner, after parallel connection, a circuit terminal voltage becomes close to the terminal voltage of the first cell piece 2 and the terminal voltage of the second cell piece 3, thus loss of output power of the cell due to the parallel connection of the first cell piece 2 and the second cell piece 3 is reduced.

If no light is irradiated onto surfaces of the first cell piece 2 and the second cell piece 3, or the surfaces of the first cell piece 2 and the second cell piece 3 are blocked so that neither of the first cell piece 2 and the second cell piece 3 works or an output thereof is smaller than other photovoltaic tiles in the loop, when there is a current in the circuit, the current will continue to flow to the first cell piece 2 and the second cell piece 3, causing the first cell piece 2 and the second cell piece 3 to generate heat. For this reason, as shown in Figs. 6, 8 and 9, the photovoltaic tile provided in an embodiment of the disclosure further includes a bypass module S3 connected in parallel with the first cell piece 2 and the second cell piece 3. When neither of the first cell piece 2 and the second cell piece 3 works normally, the current existing in the circuit flows directly through the bypass module S3. In this manner, in the case where there is a current in the circuit, the current is prevented from flowing into the first cell piece 2 and the second cell piece 3 to cause heat generation problems of the first cell piece 2 and the second cell piece 3, thus fundamentally solving the problem with power consumption due to the heat generation of the first cell piece 2 and the second cell piece 3.

In some embodiments, as shown in Fig. 6, in an embodiment of the disclosure, the photovoltaic tile also includes a first reverse charging prevention module S1 and a second reverse charging prevention module S2. The first cell piece 2 is connected in series with the first reverse charging prevention module S1, and a positive pole of the first cell piece 2 is connected to the first reverse charging prevention module S1. In this manner, the positive connection terminal U+ is electrically connected to the first cell piece 2 through the first reverse charging prevention module S1 so that when the first cell piece 2 is unusable due to damage or being blocked, the first reverse charging prevention module S1 is used to prevent the first cell piece 2 from being charged when there is a current in the reverse charging prevention circuit. Similarly, the second cell piece 3 is connected in series with the second reverse charging prevention module S2, and a positive pole of the second cell piece 3 is connected to the second reverse charging prevention module S2. In this manner, the positive connection terminal U+ is electrically connected to the second cell piece 3 through the second reverse charging prevention module S2 so that when the second cell piece 3 is unusable due to damage or being blocked, the second reverse charging prevention module S2 is used to prevent the second cell piece 3 from being charged when there is a current in the reverse charging prevention circuit. In view of the above, in the embodiment of the disclosure, the second cell piece 3 and the first cell piece 2 are connected in parallel, and the first reverse charging prevention module S1 is added to protect the first cell piece 2, while the second reverse charging prevention module S2 is added to protect the second cell piece 3. Thus, when one of the cell pieces is unusable, the first reverse charging prevention module S1 or the second reverse charging prevention module S2 can prevent a current in the circuit to charge the first cell piece 2 or the second cell piece 3 respectively connected to the first and second reverse charging prevention module S1 and S2, thereby eradicating a hot spot effect and energy waste, and thus achieving the purpose of protecting the first cell piece 2 and the second cell piece 3.

In order to facilitate the description below, a branch circuit where the first reverse charging prevention module S1 is located is defined as the first reverse charging prevention branch, a branch circuit where the second reverse charging prevention module S2 is located is defined as the second reverse charging prevention branch, and a circuit formed by connecting the first reverse charging prevention branch, the second reverse charging prevention branch and a branch where the bypass module S3 is located in parallel is defined as the reverse charging prevention circuit.

As shown in Fig. 6, if there is a current in the reverse charging prevention circuit, in the case where the first cell piece 2 and the second cell piece 3 are blocked or damaged, the current can directly flow out of the reverse charging prevention circuit of the photovoltaic tile where the first cell piece 2 and the second cell piece 3 are located through the bypass module S3, so as to prevent the first reverse charging prevention module S1 and the second reverse charging prevention module S2 from consuming the current.

In some embodiments, as shown in Figs. 1 and 3, in order to avoid damage to the electronic device caused by open environment, in an embodiment of the disclosure, the photovoltaic tile further includes a junction box 102 disposed on an inner surface of the flat plate portion 10. The first reverse charging prevention module S1, the second reverse charging prevention module S2 and the bypass module S3 are all disposed in the junction box 102. As such, not only the first reverse charging prevention module S1, the second reverse charging prevention module S2 and the bypass module S3 are protected by the junction box 102, the flat plate portion 10 also serves as a protective umbrella for the junction box 102, protecting the junction box 102 from damage due to direct sunlight, and thus realizing a secondary protection for the first reverse charging prevention module S1, the second reverse charging prevention module S2 and the bypass module S3. Further, if one or more of the first reverse charging prevention module S1, the second reverse charging prevention module S2 and the bypass module S3 are damaged, the damaged module may be directly removed from the junction box 102 and replaced with a new one, thus realizing relatively convenient maintenance of the first reverse charging prevention module S1, the second reverse charging prevention module S2 and the bypass module S3.

It should be noted that, as shown in Fig. 6, each of the first reverse charging prevention module S1, the second reverse charging prevention module S2 and the bypass module S3 is a reverse charging prevention devices having a unidirectional conduction function, such as a diode, wherein the cathode of the diode is connected to the positive connection terminal U+, and the anode of the diode is connected to the positive pole of the second cell piece 3 or the positive pole of the first cell piece 2.

It should be noted that, as shown in Figs. 1, 3 and 4, if the inner surface of the flat plate portion 10 is also provided with the mounting block 101, the position of the junction box 102 should be set to avoid the mounting block 101. Generally, a distance between the mounting block 101 and the junction box 102 should not be less than 40 mm. Obviously, the distance between the two may be set according to actual conditions. At the same time, as shown in Fig. 4, a bus bar 103 of the photovoltaic tile may be correspondingly disposed on the inner surface of the bulging portion to prevent wear of the bus bar 103 due to long-term open-air installation, while facilitating a lead wire to be connected to the first reverse charging prevention module S1, the second reverse charging prevention module S2 and the bypass module S3 in the junction box 102.

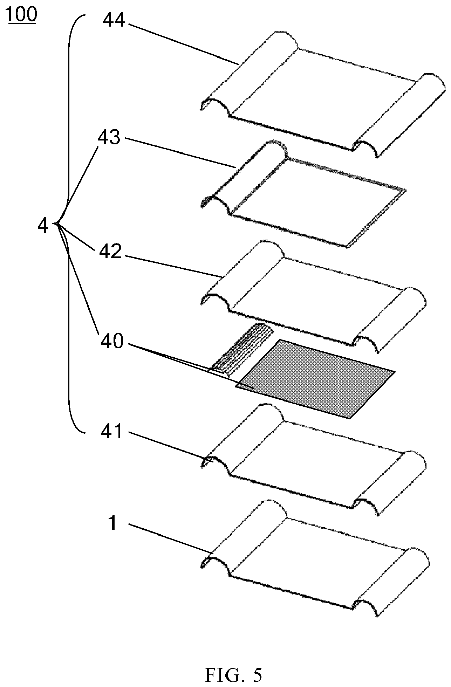

In order to ensure a packaging effect of the second cell piece 3 and the first cell piece 2, as shown in Fig. 5, in an embodiment of the disclosure, the photovoltaic tile further includes a cell package layer 4 for packaging the first cell piece 2 and the second cell piece 3. The cell package layer 4 includes a first package layer 41 between a cell layer 40 formed by the first cell piece 2 and the second cell piece 3 and an outer surface of the tile base 1, and a second package layer formed on a light receiving surface of the cell layer 40. The first package layer 41 includes a first adhesive film, and the second package layer includes a second adhesive film 42, a seal layer 43 and a transparent package plate 44 stacked sequentially on the light receiving surface of the cell layer 40. The seal layer 43 has an insulation and waterproofing function, and may employ butyl rubber or the like. The first adhesive film and the second adhesive film 42 may employ a highly water-resistant polyolefin adhesive film, such as a POE (polyolefin elastomer) adhesive film. The transparent package plate 44 may employ a flexible front plate, a glass front plate, or the like, and is highly water-resistant, so as to ensure a longer service life of the cell layer 40.

When the tile base 1 is made of a light transmitting material, it may serves as a photovoltaic tile transparent package plate 44. Thus, the tile base 1 provides both an overall shape of the photovoltaic tile and functions of the transparent package plate 44. The tile base 1 may be replaced by a waterproof backsheet material. The backsheet material is an aluminium - containing backsheet, a TPT (Tedlar PET Tedlar, polyvinyl fluoride composite film) backsheet, or the like.

In some embodiments, as shown in Figs. 1 to 5, in an embodiment of the disclosure, the bulging portion has an arc structure, and a cross section of the bulging portion (along the width direction of the tile base 1) has a semicircular shape. The second cell piece 3 is formed on the outer surface of one of the bulging portions, and the first cell piece 2 is formed on the outer surface of the flat plate portion 10. When the bulging portion serves as a lap for the tile base 1, the number of the bulging portions is two, i.e., the first bulging portion 11 and the second bulging portion 12. The flat plate portion 10 is disposed between the first bulging portion 11 and the second bulging portion 12. As shown in Figs. 1 and 2, a bulging outer diameter at an end of the first bulging portion 11 flush with a first end *a* of the flat plate portion 10 is equal to a bulging inner diameter at an end of the first bulging portion 11 flush with a second end *b* of the flat plate portion 10. A bulging outer diameter at an end of the second bulging portion 12 flush with the first end *a* of the flat plate portion 10 is equal to a bulging inner diameter at an end of the second bulging portion 12 flush with the second end *b* of the flat plate portion 10. A bulging radius of an inner surface the first bulging portion 11 is equal to a bulging radius of an outer surface of the second bulging portion 12. Thus, the first bulging portion 11 and the second bulging portion 12 exhibit a flare-like structure with one end relatively small and the other end relatively large, so that two photovoltaic tiles may be lapped along the length direction of the tile base 1.

In order to prevent rainwater from being poured backward, two adjacent photovoltaic tiles may be lapped together from left or from right along the width direction of the tile base 1 according to an annual wind direction in the environment where the photovoltaic tile is located. As an example, the inner surface of the first bulging portion 11 of one photovoltaic tile is in contact with the outer surface of the second bulging portion 12 of another photovoltaic tile. As another example, the outer surface of the first bulging portion 11 of one of the photovoltaic tiles is in contact with the inner surface of the second bulging portion 12 of the other photovoltaic tile.

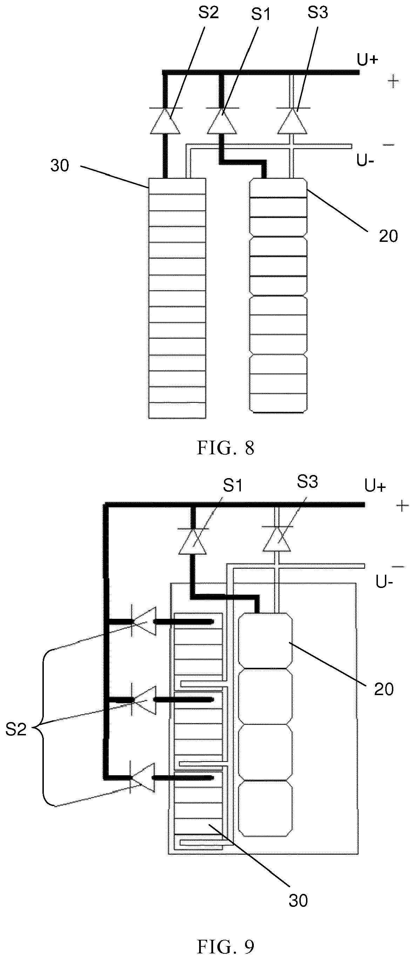

As shown in Fig. 9, some other embodiments of the disclosure further provide a photovoltaic tile 200, which differs from the photovoltaic tile 100 provided in any one of the above embodiments in that:

as shown in Figs. 7 to 9, in the photovoltaic tile 200, the first cell piece 2 includes a plurality of sub-first cell pieces 20 connected in series. The first cell piece 2 is provided on the flat plate portion 10, and each portion of the first cell piece 2 has the same light receiving area and irradiation intensity, so the arrangement of the plurality of sub-first cell pieces 20 is relatively free.

Obviously, the specific structure of the first cell piece 2 included in the photovoltaic tile 100 may also be set with reference to Figs. 8 and 9.

As shown in Figs. 8 to 9, in the photovoltaic tile 200, the second cell piece 3 includes a plurality sets of sub-second cell pieces 30 connected in parallel. The second reverse charging prevention branch includes a plurality of reverse charging prevention shunts (sub-branches) connected in parallel between the positive connection terminal U+ and the negative connection terminal U-. Each reverse charging prevention shunt includes one sub-reverse charging prevention module, and the sub-reverse charging prevention modules included in the plurality of reverse charging prevention shunts together form the reverse charging prevention module. In other words, the second reverse charging prevention module includes a plurality of sub-second reverse charging prevention modules.

The plurality of sub-second reverse charging prevention modules are connected in series with the plurality sets of sub-second cell pieces in a one-to-one relation (that is, one sub-second reverse charging prevention module is connected in series with one corresponding set of sub-second cell pieces), and the positive poles of the plurality sets of sub-second cell pieces are connected to the plurality of sub-second reverse charging prevention modules in a one-to-one relation so that the sub-second reverse charging prevention module is used to prevent, when a current is present in the circuit, the current from flowing into a blocked or damaged set of sub-second cell pieces. In that, each set of the sub-second cell pieces includes at least two sub-second cell pieces 30 connected in series or in parallel.

As shown in Figs. 8 and 9, when the second cell piece 2 includes a plurality sets of sub-second cell pieces connected in parallel, the sub-reverse charging prevention module included in each reverse charging prevention branch is a diode, wherein a cathode of the diode is connected to the positive connection terminal U+, and an anode of the diode is connected to a positive pole of the second or first cell piece.

It should be understood that, as shown in Figs. 7 to 9, in an embodiment of the disclosure, two adjacent sub-first cell pieces 20 are independent of each other to ensure that the two adjacent sub-first cell pieces 20 are independent of and insulated from each other. Similarly, two adjacent sub-second cell pieces 30 are also kept independent of each other.

Considering that the second cell piece 3 is disposed on the outer surface of the bulging portion and a bulging height of the bulging portion varies depending on the position, light receiving areas and irradiation intensities at different portions of the second cell piece 3 are different, while the first cell piece 2 formed by the flat plate portion 10 does not have such a problem. Therefore, the second cell pieces 3 are disposed at selected positions of the bulging portion having a similar bulging height. Specifically, when the second cell piece 3 includes a plurality sets of sub-second cell pieces, the plurality sets of sub-second cell pieces are disposed at positions having a similar bulging height.

As an example, as shown in Fig. 7, in an embodiment of the disclosure, the bulging portion has a similar bulging height along the length direction of the tile base 1. Therefore, in the embodiment of the disclosure, each of the plurality sets of sub-second cell pieces is disposed on the outer surface of the bulging portion along the length direction (i.e., the direction X in Fig. 7) of the tile base 1. The respective sub-second cell pieces 30 of each set of sub-second cell pieces are arranged on the bulging portion along the length direction of the tile base 1 so that each sub-second cell piece 30 has a similar light receiving area and irradiation intensity. Thus, the current loss is relatively small when the respective sub-second cell pieces 30 in each set of sub-second cell pieces are connected in series.

As for the number of the sub-first cell pieces 20 and the number of the sub-second cell pieces 30, a constraint condition that a terminal voltage on all the sub-second cell pieces 30 is equal to a terminal voltage on all the sub-first cell pieces 20 after they are connected in series or parallel, as well as a constraint condition that the sub-second cell pieces 30 have the same length in the length direction of the tile base 1, need to be taken into account so as to maximize a utilization area of the bulging portion.

Further, in an embodiment of the disclosure, when the sub-second cell pieces 30 and the sub-first cell pieces 20 are connected in series or parallel, the following two requirements needs to be taken into consideration:

First, a difference between a length of the second cell piece 3 along the length direction of the tile base 1 and a length of the first cell piece 2 along the length direction of the tile base 1 is 50 mm or less, so as to ensure effective utilization of the area of the tile base 1 as well as proper architectural aesthetic.

Second, considering that when the second cell piece 3 is disposed on the outer surface of the bulging portion, the light receiving area and the irradiation intensity of the bulging portion per unit area of the second cell piece 3 are different from the case where the second cell piece 3 is disposed on the outer surface of the flat plate portion 10, resulting in that a voltage of the second cell piece 3 is 90% to 99% of a voltage of the first cell piece 2. Therefore, in an embodiment of the disclosure, when the sub-second cell pieces 30 and the sub-first cell pieces 20 are selected to be connected in series or parallel, it should be ensured that: assuming the second cell piece 3 and the first cell piece 2 are both disposed on the flat plate portion 10, the second cell piece 3 would have a voltage 1%-10% higher than the voltage of the first cell piece 2. As such, when the second cell piece 3 is provided on the bulging portion, a power generation loss due to uneven light reception of the second cell piece 3 provided on the bulging portion may be offset by the original, extra voltage. Meanwhile, a terminal voltage of each set of the sub-second cell pieces may be increased by utilizing series connection so that the terminal voltage of each set of the sub-second cell pieces is made equal to a terminal voltage of the sub-first cell pieces 20 in series.

Based on the consideration of the above two requirements, in an embodiment of the disclosure, each sub-first cell piece 20 is a single crystalline silicon cell piece (HIT) with a chamfered square structure. The single crystalline silicon cell piece of such structure is regarded as a square single crystalline silicon cell piece for serial-parallel design and calculation, and the square single crystalline silicon cell is set to have a side length of 156 mm. Each sub-second cell piece 30 is a CIGS thin film solar cell (CM) with the following two specifications, the first specification of CM: length 312mm, width 43.75mm; the second specification of CM: length 211mm, width 58mm.

**Table 1. Basic parameters of a first series-parallel design of the sub-first cell pieces and the sub-second cell pieces**

| parameter name | parameter symbol | value |
|---|---|---|
| HIT voltage (V) | V_{HIT} | 0.75 |
| CM voltage (V) | V_{CM} | 0.65 |
| HIT length (mm) | L_{HIT} | 156 |
| HIT width (mm) | W_{HIT} | 156 |
| CM length (mm) | L_{CM} | 312 |
| CM width (mm) | W_{CM} | 43.75 |
| number of sub-first cell pieces cut from each HIT | n | 1 |
| HIT row spacing (mm) | Q | 1.5 |

**Table 2. Analysis result of the first series-parallel design of the sub-first cell pieces and the sub-second cell pieces**

| parameter name | parameter symbol | calculation formula | value | | | | | |
|---|---|---|---|---|---|---|---|---|
| number of HIT rows | R | R=1, 2, 3, 4, 5, 6 | 1 | 2 | 3 | 4 | 5 | 6 |
| number of HIT columns | C | C=1, 2, 3 | 1 | 1 | 1 | 1 | 1 | 1 |
| number of CMs in series | S | INT[Vₕ×(1+5%)/Vcm]+1 | 2 | 3 | 4 | 5 | 7 | 8 |
| number of CMs in parallel | k | INT[(Lₕ+50)/W_{CM}/S] | 2 | 2 | 2 | 3 | 2 | 2 |
| voltage of HIT string | Vₕ | R×C×V_{HIT} | 0.75 | 1.5 | 2.25 | 3 | 3.75 | 4.5 |
| voltage of CM string | V_{c} | S×V_{CM} | 1.3 | 1.95 | 2.6 | 3.25 | 4.55 | 5.2 |
| length of HIT string | Lₕ | (R-1)×Q+R×W_{HIT}/N | 156 | 313.5 | 471 | 628.5 | 786 | 943.5 |
| length of CM string | L_{c} | S×P×W_{CM} | 175 | 262.5 | 350 | 656.25 | 612.5 | 700 |
| difference in length | ΔL | Lₕ-L_{c} | -19 | 51 | 121 | -27.75 | 173.5 | 243.5 |
| difference in voltage | ΔV | (V_{c}Nₕ-1)% | 73.33 | 30.00 | 15.56 | 8.33 | 21.33 | 15.56 |

**Table 3. Basic parameters of a second series-parallel design of the sub-first cell pieces and the sub-second cell pieces**

| parameter name | parameter symbol | value |
|---|---|---|
| HIT voltage (V) | V_{HIT} | 0.75 |
| CM voltage (V) | V_{CM} | 0.65 |
| HIT length (mm) | L_{HIT} | 156 |
| HIT width (mm) | W_{HIT} | 156 |
| CM length (mm) | L_{CM} | 312 |
| CM width (mm) | W_{CM} | 43.75 |
| number of sub-first cell pieces cut from each HIT | n | 3 |
| HIT row spacing (mm) | Q | 1.5 |

**Table 4. Analysis result of the second series-parallel design of the sub-first cell pieces and the sub-second cell pieces**

| parameter name | parameter symbol | calculation formula | value | | | | | | | | | | | | |
|---|---|---|---|---|---|---|---|---|---|---|---|---|---|---|---|
| number of HIT rows | R | R= an integer from 4 to 16 | 4 | 5 | 6 | 7 | 8 | 9 | 10 | 11 | 12 | 13 | 14 | 15 | 16 |
| number of HIT columns | C | C=1, 2 | 1 | 1 | 1 | 1 | 1 | 1 | 1 | 1 | 1 | 1 | 1 | 1 | 1 |
| number of CMs in series | S | INT[Vₕ×(1+5%)/Vcm]+1 | 5 | 7 | 8 | 9 | 10 | 11 | 13 | 14 | 15 | 16 | 17 | 19 | 20 |
| number of CMs in parallel | k | INT[(Lₕ+50)/W_{CM}/S] | 1 | 1 | 1 | 1 | 1 | 1 | 1 | 1 | 1 | 1 | 1 | 1 | 1 |
| voltage of HIT string | Vₕ | R×C×V_{HIT} | 3 | 3.75 | 4.5 | 5.25 | 6 | 6.75 | 7.5 | 8.25 | 9 | 9.75 | 10.5 | 11.25 | 12 |
| voltage of CM string | V_{c} | S×V_{CM} | 3.25 | 4.55 | 5.2 | 5.85 | 6.5 | 7.15 | 8.45 | 9.1 | 9.75 | 10.4 | 11.05 | 12.35 | 13 |
| length of HIT string | Lₕ | (R-1)×Q+R×W_{HIT}/N | 212.5 | 266 | 319.5 | 373 | 426.5 | 480 | 533.5 | 587 | 640.5 | 694 | 747.5 | 801 | 854.5 |
| length of CM string | L_{c} | S×P×W _{CM} | 218.75 | 306.25 | 35.0 | 393.75 | 437.5 | 481.25 | 568.75 | 612.5 | 656.25 | 700 | 743.75 | 831.25 | 875 |
| difference in length | ΔL | Lₕ-L_{c} | -6.25 | -40.25 | -30.5 | -20.75 | -11 | -1.25 | -35.25 | -25.5 | -15.75 | -6 | 3.7 5 | -30.25 | -20.5 |
| difference in voltage | ΔV | (V_{c}/Vₕ-1)% | 8.33 | 21.33 | 15.56 | 11.43 | 8.33 | 5.93 | 12.67 | 10.30 | 8.33 | 6.67 | 5.24 | 9.78 | 8.33 |

In Tables 2 and 4, the number of HIT columns refers to the number of columns in which the HIT is arranged along the width direction (i.e., the direction Y) of the tile base 1. The number of HIT rows refers to the number of rows in which the HIT is arranged along the length direction (i.e. the direction X) of the tile base 1. The number of CMs in series refers to the number of sub-second cell pieces 30 included in each set of sub-second cell pieces. The number of CMs in parallel refers to the number of sets of the sub-second cell pieces 30. The voltage of HIT string refers to a terminal voltage of a plurality of sub-first cell pieces 20 connected in series. The voltage of CM string refers to a terminal voltage of each set of sub-second cell pieces 30. The difference in length refers to a difference in length between all the sub-second cell pieces 30 and all the sub-first cell pieces 20 along the length direction of the tile base 1. The difference in voltage refers to a percentage ratio between a voltage difference and the terminal voltage of the plurality of sub-first cell pieces 20 connected in series, wherein the voltage difference refers to a difference between the terminal voltage of each set of sub-second cell pieces 30 and the terminal voltage of the plurality of sub-first cell pieces 20 connected in series.

It can be found from Tables 1 and 2 that in the embodiment of the disclosure, an optional result of the first series-parallel design of the sub-first cell pieces 20 and the sub-second cell pieces 30 is as shown in Fig. 9, in which the number of the sub-first cell pieces 20 is four, each of which does not need to be cut; the number of sets of the sub-second cell pieces 30 is three, and each set includes five sub-second cell pieces 30 connected in series. The four sub-first cell pieces 20 are arranged in a column along the length direction of the tile base 1. The three sets of sub-second cell pieces are arranged in a column along the length direction of the tile base 1. Each set of the sub-second cell pieces are arranged in a column along the length direction of the tile base 1. The specific circuit diagram is as shown in Fig. 9.

It can be found from Tables 3 and 4 that in the embodiment of the disclosure, the second series-parallel design analysis of the sub-first cell pieces 20 and the sub-second cell pieces 30 has more optional results. Taking one of the optional results as an example, specifically, as shown in Fig. 8, along the length direction of the tile base 1, twelve sub-first cell pieces 20 are connected in series, and fifteen sub-second cell pieces 30 are connected in series. In the analysis results of the second series-parallel design of the sub-first cell pieces 20 and the sub-second cell pieces 30 in the embodiment of the disclosure, the twelve sub-first cell pieces 20 of the embodiment are obtained by cutting four complete (intact) single crystalline silicon cell pieces.

By comparison, it can be found that according to the optional result of the first series-parallel design analysis results, it is not necessary to cut a single crystalline silicon cell piece, and according to the optional result of the second series-parallel design analysis results, it is necessary to cut a single crystalline silicon cell piece. However, since there are less parallel structures in the optional result of the second series-parallel design analysis results, the reverse charging prevention device and the bus bar 103 (see Fig. 4) may be saved. Meanwhile, by adopting the optional result of the first series-parallel design analysis results and the optional result of the second series-parallel design analysis results, voltages of the first cell piece 2 and the second cell piece 3 in parallel may be matched as much as possible (i.e., the voltages are as equal as possible) to avoid voltage loss while avoiding current loss.

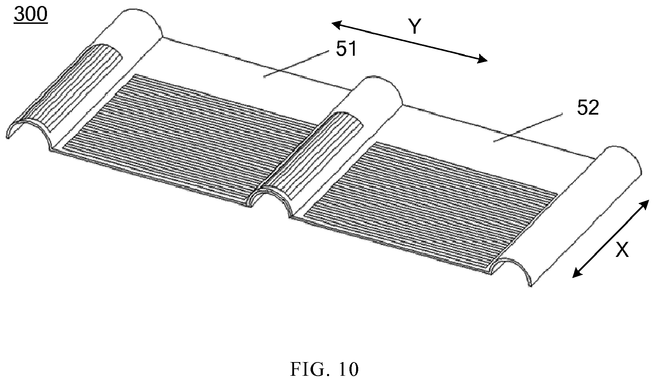

As shown Fig. 10, some embodiments of the disclosure further provide a photovoltaic system 300 including a plurality of the photovoltaic tiles 100 or photovoltaic tiles 200 in the above embodiments.

The beneficial effects of the photovoltaic system provided in an embodiment of the disclosure compared with related art are the same as those of the photovoltaic tile provided by the technical solutions in the above embodiments, and thus a redundant description thereof is omitted.

Specifically, in an embodiment of the present disclosure, the first cell piece 2 and the second cell piece 3 included in each photovoltaic tile are connected in parallel, and the respective photovoltaic tiles are connected in series to ensure maximum current output.

In some embodiments, as shown in Figs. 1 to 5, and Figs. 7 to 10, the number of bulging portions included in each photovoltaic tile is at least two. The at least two bulging portions include a first bulging portion 11 and a second bulging portion 12 respectively connected to the two ends of the tile base 1 included in the photovoltaic tile in the width direction (i.e., the direction Y) of the tile base 1. Further, among two photovoltaic tiles (i.e., a first photovoltaic tile 51 and a second photovoltaic tile 52) adjacent in the width direction of the tile base 1 (i.e., the direction Y), an outer surface of the second bulging portion 12 included in one photovoltaic tile is in contact with an inner surface of the first bulging portion 11 included in the adjacent photovoltaic tile. Two photovoltaic tiles adjacent in the length direction (i.e., the direction X) of the tile base 1 are lapped together.

Two photovoltaic tiles adjacent in the length direction of the tile base 1 are lapped together. Specifically, among two photovoltaic tiles adjacent in the width direction of the tile base 1 included in each photovoltaic tile, an outer surface of the first bulging portion 11 included in one photovoltaic tile is in contact with an inner surface of the first bulging portion 11 included in the adjacent photovoltaic tile, and an outer surface of the second bulging portion 12 included in one photovoltaic tile is in contact with an inner surface of the second bulging portion 12 included in the adjacent photovoltaic tile.

The number of bulging portions included in the photovoltaic tile may also be three, four or more, which is not specifically limited herein.

In the description of the above embodiments, the specific features, structures, materials or characteristics may be combined in any suitable manner in any one or more embodiments or examples.

The foregoing are merely specific embodiments of the present disclosure, and the protection scope of the disclosure is not limited thereto. Any change or modification that can be easily thought by those skilled in the art within the technical scope disclosed by the disclosure shall fall in the protection scope of the disclosure. Therefore, the scope of protection of the present disclosure shall be determined by the scope of the claims.

## Claims

1. A photovoltaic tile (100; 200), comprising a tile base (1), a first cell piece (2) and a second cell piece (3), wherein the tile base (1) comprises a flat plate portion (10) and at least one bulging portion (11, 12) connected to the flat plate portion (10), the first cell piece (2) is disposed on an outer surface of the flat plate portion (10), and the second cell piece (3) is disposed on and matched with an outer surface of at least one of the bulging portions (11, 12).

2. The photovoltaic tile (100; 200) according to claim 1, wherein the first cell piece (2) is a flat cell piece and the second cell piece (3) is a flexible cell piece.

3. The photovoltaic tile (100; 200) according to claim 2, wherein the first cell piece (2) and the second cell piece (3) are connected in parallel.

4. The photovoltaic tile (100; 200) according to claim 3, wherein a terminal voltage of the first cell piece (2) is equal to a terminal voltage of the second cell piece (3).

5. The photovoltaic tile (100; 200) according to claim 3, further comprising a bypass module (S3) connected in parallel with the first cell piece (2) and the second cell piece (3).

6. The photovoltaic tile (100; 200) according to claim 5, further comprising a first reverse charging prevention module (S1) and a second reverse charging prevention module (S2);
wherein the first cell piece (2) is connected in series with the first reverse charging prevention module (SI), and a positive pole of the first cell piece (2) is connected to the first reverse charging prevention module (S1); and
wherein the second cell piece (3) is connected in series with the second reverse charging prevention module (S2), and a positive pole of the second cell piece (3) is connected to the second reverse charging prevention module (S2).

7. The photovoltaic tile (100; 200) according to claim 6, further comprising a junction box (102) disposed on an inner surface of the flat plate portion (10), wherein each of the first reverse charging prevention module (SI), the second reverse charging prevention module (S2) and the bypass module (S3) is disposed in the junction box (102).

8. The photovoltaic tile (100; 200) according to any one of claims 2 to 6, wherein the first cell piece (2) comprises a plurality of sub-first cell pieces (20) connected in series.

9. The photovoltaic tile (100; 200) according to claim 6, wherein the second cell piece (3) comprises a plurality sets of sub-second cell pieces (30) connected in parallel, wherein the second reverse charging prevention module (S2) comprises a plurality of sub-second reverse charging prevention modules connected in series with the plurality sets of sub-second cell pieces (30) in a one-to-one relation, and wherein positive poles of the plurality sets of sub-second cell pieces (30) are connected to the plurality of sub-second reverse charging prevention modules in a one-to-one relation.

10. The photovoltaic tile (100; 200) according to claim 9, wherein the plurality sets of sub-second cell pieces (30) are arranged on the outer surface of the bulging portion (11) along a length direction (X) of the tile base (1).

11. The photovoltaic tile (100; 200) according to any one of claims 1 to 10, wherein a difference between a length of the first cell piece (2) along the length direction (X) of the tile base (1) and a length of the second cell piece (3) along the length direction (X) of the tile base (1) is less than or equal to 50 mm.

12. The photovoltaic tile (100; 200) according to any one of claims 1 to 10, wherein the photovoltaic tile (100; 200) further comprises a cell package layer (4) for packaging the first cell piece (2) and the second cell piece (3).

13. A photovoltaic system (300) comprising the photovoltaic tile (100; 200) according to any one of claims 1 to 12.

14. The photovoltaic system (300) according to claim 13, wherein each of the photovoltaic tiles (100; 200) is connected in series.

15. The photovoltaic system (300) according to claim 13, wherein each of the photovoltaic tiles (100; 200) comprises at least two bulging portions (11, 12) comprising a first bulging portion (11) and a second bulging portion (12), the first bulging portion (11) and the second bulging portion (12) being connected at two ends of the tile base (1) included in the photovoltaic tile (100; 200) in a width direction (Y) of the tile base (1), respectively;
wherein among two of the photovoltaic tiles adjacent in the width direction (Y) of the tile base (1), an outer surface of the second bulging portion (12) included in one photovoltaic tile is in contact with an inner surface of the first bulging portion (11) included in the other photovoltaic tile; and
wherein two of the photovoltaic tiles adjacent in a length direction (X) of the tile base (1) are lapped together.
